# EUROPEAN PATENT APPLICATION

(11) **EP 3 671 907 A1**
(43) Date of publication of application: **24.06.2020**
(21) Application number: 18306792.5
(22) Date of filing: 21.12.2018
(51) Int. Cl.: H01M 4/04, H01M 4/133, H01M 4/1393, H01M 4/36, H01M 4/38, H01M 4/587, H01M 4/62, C23C 16/442, C23C 16/44, C23C 16/24, C23C 16/08, C23C 16/18

(54) **COMPOSITE PARTICULATE MATERIALS**

(71) Applicant: IMERTECH SAS, 75015 Paris (FR)
(72) Inventor: The designation of the inventor has not yet been filed
(74) Representative: Haseltine Lake Kempner LLP

(57) **Abstract**

A method of forming a composite particulate material by Chemical Vapour Deposition (CVD) comprises: contacting fluidised particles of a first material with a precursor gas in the presence of a catalyst in a reaction chamber of a fluidised bed reactor at a pressure greater than about 100 Torr; and heating the reaction chamber to a temperature at which the precursor gas, in the presence of the catalyst, decomposes to deposit nanostructures of a second material onto the fluidised particles of the first material. The method is particularly suited to the large-scale production of composite particulate materials.

## Description

### TECHNICAL FIELD

The present invention is directed to composite particulate materials, methods of forming composite particulate materials, electrodes for an electrochemical cells, and methods of forming electrodes for electrochemical cells.

### BACKGROUND TO THE INVENTION

Composite particulate materials may be formed by decorating the surface of particles of a first material with a second material. The second material deposited onto the first material may be nanostructured. For example, the second material may form nanowires which project from the surface of the particles of the first material. Composite particulate materials, typically formed from electrical conductors or semiconductors, have been proposed as electrode active materials for electrochemical cells such as lithium-ion batteries. However, such composite particulate materials are currently formed using low-pressure or ultrahigh vacuum materials deposition techniques which require use of specialised equipment able to maintain and withstand low pressures and which are generally only suited to batch manufacturing processes and, in particular, relatively small batch sizes.

### SUMMARY OF THE INVENTION

According to a first aspect, the present invention is directed to a method of forming a composite particulate material by Chemical Vapour Deposition (CVD), the method comprising: contacting fluidised particles of a first material with a precursor gas in the presence of a catalyst in a reaction chamber of a fluidised bed reactor at a pressure greater than about 100 Torr; and heating the reaction chamber to a temperature at which the precursor gas, in the presence of the catalyst, decomposes to deposit nanostructures of a second material onto the fluidised particles of the first material.

According to a second aspect, the present invention is directed to a method of manufacturing an electrode for an electrochemical cell, the method comprising: forming a composite particulate material by the method according to the first aspect, the composite particulate material comprising particles having a particle core formed of a first material and nanostructures of a second material attached to the particle core; and forming at least part of the electrode from the composite particulate material without substantial detachment of the nanostructures of the second material from the particle cores of the first material.

According to a third aspect, the present invention is directed to a composite particulate material formed by the method according to the first aspect.

According to a fourth aspect, the present invention is directed to an electrode for an electrochemical cell manufactured by the method according to the second aspect.

### DETAILED DESCRIPTION OF THE INVENTION

It has surprisingly been found that composite particulate materials can be manufactured by Chemical Vapour Deposition (CVD) in a fluidised bed reactor at a pressure greater than 100 Torr. In particular, the method of manufacture comprises contacting fluidised particles of a first material with a precursor gas in the presence of a catalyst in a reaction chamber of the fluidised bed reactor at a pressure greater than 100 Torr, and heating the reaction chamber to a temperature at which the precursor gas, in the presence of the catalyst, decomposes to deposit nanostructures of a second material onto the fluidised particles of the first material. This method is particularly suited to the production of very large batches (e.g. 100 kg, 500 kg, 1000 kg and 5000 kg batch sizes) of composite particulate materials.

### Pressure

It will be appreciated that references to the pressure at which the method is carried out are to be interpreted as the pressure within the reaction chamber during the method (i.e. the gas pressure within the reaction chamber).

Since the method is carried out at a pressure greater than about 100 Torr, specialised vacuum or pressure pumps or seals are not required, and the use of high-strength equipment capable of withstanding the high forces typically exerted by strong vacuums or pressures is also not required. In addition, at pressures greater than about 100 Torr, particle fluidisation techniques, such as gas fluidisation, become feasible. This in turn enables the production of very large batches of, and/or the continuous production of, composite particulate materials. In contrast, known alternative methods for manufacturing composite particulate materials require the use of vacuum conditions, precluding effective particle fluidisation and severely restricting batch sizes.

The method may comprise contacting the fluidised particles of the first material with the precursor gas at a pressure which is no less than about 150 Torr, for example, no less than about 200 Torr, or no less than about 250 Torr, or no less than about 300 Torr, or no less than about 350 Torr, or no less than about 400 Torr, or no less than about 450 Torr, or no less than about 500 Torr, or no less than about 550 Torr, or no less than about or no less than about 600 Torr, or no less than about 650 Torr.

The method may comprise contacting the fluidised particles of the first material with the precursor gas at a pressure which is no greater than about 7500 Torr, for example, no greater than about 7000 Torr, or no greater than about 6500 Torr, or no greater than about 6000 Torr, or no greater than about 5500 Torr, or no greater than about 5000 Torr, or no greater than about 4500 Torr, or no greater than about 4000 Torr, or no greater than about 3500 Torr, or no greater than about 3000 Torr, or no greater than about 2500 Torr, or no greater than about 2000 Torr, or no greater than about 1500 Torr, or no greater than about 1000 Torr.

The method may comprise contacting the fluidised particles of the first material with the precursor gas at a pressure greater than about 100 Torr and less than or equal to about 7500 Torr, for example, greater than about 100 Torr and less than or equal to about 7000 Torr, or greater than about 100 Torr and less than or equal to about 6500 Torr, or greater than about 100 Torr and less than or equal to about 6000 Torr, or greater than about 100 Torr and less than or equal to about 5000 Torr, or greater than about 100 Torr and less than or equal to about 4000 Torr, or greater than about 100 Torr and less than or equal to about 3000 Torr, or greater than about 100 Torr and less than or equal to about 2000 Torr, or greater than about 100 Torr and less than or equal to about 1500 Torr, or greater than about 100 Torr and less than or equal to about 1000 Torr, or from about 150 Torr to about 7500 Torr, or from about 150 Torr to about 7000 Torr, or from about 150 Torr to about 6500 Torr, or from about 150 Torr to about 6000 Torr, or from about 150 Torr to about 5000 Torr, or from about 150 Torr to about 4000 Torr, or from about 150 Torr to about 3000 Torr, or from about 150 Torr to about 2000 Torr, or from about 150 Torr to about 1500 Torr, or from about 150 Torr to about 1000 Torr, or from about 200 Torr to about 7500 Torr, or from about 200 Torr to about 6000 Torr, or from about 200 Torr to about 5000 Torr, or from about 200 Torr to about 4000 Torr, or from about 200 Torr to about 3000 Torr, or from about 200 Torr to about 2000 Torr, or from about 200 Torr to about 1500 Torr, or from about 200 Torr to about 1000 Torr, or from about 250 Torr to about 7500 Torr, or from about 250 Torr to about 6000 Torr, or from about 250 Torr to about 5000 Torr, or from about 250 Torr to about 4000 Torr, or from about 250 Torr to about 3000 Torr, or from about 250 Torr to about 2000 Torr, or from about 250 Torr to about 1500 Torr, or from about 250 Torr to about 1000 Torr, or from about 300 Torr to about 7500 Torr, or from about 300 Torr to about 6000 Torr, or from about 300 Torr to about 5000 Torr, or from about 300 Torr to about 4000 Torr, or from about 300 Torr to about 3000 Torr, or from about 300 Torr to about 2000 Torr, or from about 300 Torr to about 1500 Torr, or from about 300 Torr to about 1000 Torr, or from about 350 Torr to about 7500 Torr, or from about 350 Torr to about 6000 Torr, or from about 350 Torr to about 5000 Torr, or from about 350 Torr to about 4000 Torr, or from about 350 Torr to about 3000 Torr, or from about 350 Torr to about 2000 Torr, or from about 350 Torr to about 1500 Torr, or from about 350 Torr to about 1000 Torr, or from about 400 Torr to about 7500 Torr, or from about 400 Torr to about 6000 Torr, or from about 400 Torr to about 5000 Torr, or from about 400 Torr to about 4000 Torr, or from about 400 Torr to about 3000 Torr, or from about 400 Torr to about 2000 Torr, or from about 400 Torr to about 1500 Torr, or from about 400 Torr to about 1000 Torr, or from about 450 Torr to about 7500 Torr, or from about 450 Torr to about 6000 Torr, or from about 450 Torr to about 5000 Torr, or from about 400 Torr to about 4000 Torr, or from about 450 Torr to about 3000 Torr, or from about 450 Torr to about 2000 Torr, or from about 450 Torr to about 1500 Torr, or from about 450 Torr to about 1000 Torr, or from about 500 Torr to about 7500 Torr, or from about 500 Torr to about 6000 Torr, or from about 500 Torr to about 5000 Torr, or from about 500 Torr to about 4000 Torr, or from about 500 Torr to about 3000 Torr, or from about 500 Torr to about 2000 Torr, or from about 500 Torr to about 1500 Torr, or from about 500 Torr to about 1000 Torr, or from about 550 Torr to about 7500 Torr, or from about 550 Torr to about 6000 Torr, or from about 550 Torr to about 5000 Torr, or from about 550 Torr to about 4000 Torr, or from about 550 Torr to about 3000 Torr, or from about 550 Torr to about 2000 Torr, or from about 550 Torr to about 1500 Torr, or from about 550 Torr to about 1000 Torr, or from about 600 Torr to about 7500 Torr, or from about 600 Torr to about 6000 Torr, or from about 600 Torr to about 5000 Torr, or from about 600 Torr to about 4000 Torr, or from about 600 Torr to about 3000 Torr, or from about 600 Torr to about 2000 Torr, or from about 600 Torr to about 1500 Torr, or from about 600 Torr to about 1000 Torr, or from about 650 Torr to about 7500 Torr, or from about 650 Torr to about 6000 Torr, or from about 650 Torr to about 5000 Torr, or from about 650 Torr to about 4000 Torr, or from about 650 Torr to about 3000 Torr, or from about 650 Torr to about 2000 Torr, or from about 650 Torr to about 1500 Torr, or from about 650 Torr to about 1000 Torr.

The method may be carried out at atmospheric pressure. Atmospheric pressure is about 1013.25 mbar, equivalent to about 101.325 kPa or about 760 Torr. The method may be carried out at near-atmospheric pressure, for example at a pressure from about 50 % to about 200 % of atmospheric pressure, or from about 75 % to about 150 % of atmospheric pressure, or from about 90 % to about 125 % of atmospheric pressure.

### Method

The method may comprise: fluidising the particles of the first material in the reaction chamber at atmospheric or near-atmospheric pressure; and supplying the precursor gas to the reaction chamber, thereby bringing the fluidised particles and precursor gas into contact. The method may comprise first fluidising the particles of the first material and then supplying the precursor gas to the reaction chamber. Alternatively, the method may comprise supplying the precursor gas to the reaction prior to or during fluidising the particles of the first material.

The particles of the first material may be mechanically fluidised. For example, the method may comprise mechanically fluidising the particles of the first material. Mechanically fluidising the particles of the first material may comprise mechanically agitating the particles using an agitator (e.g. a paddle) and/or tumbling the particles in the reaction chamber.

Additionally or alternatively, the particles may be gas-fluidised. For example, the method may comprise fluidising the particles in a flow of carrier gas. The carrier gas may be inert. For example, the carrier gas may comprise (e.g. be) a noble gas such as neon (Ne) or argon (Ar).

The method may be a method of forming the composite particulate material by Liquid Injection Chemical Vapour Deposition (LICVD). The method may be a method of forming the composite particulate material by Direct Liquid Injection Chemical Vapour Deposition (DLICVD). In DLICVD, volatile liquid precursors are typically injected into a reaction chamber, or into a vaporisation chamber, the liquid precursors evaporating on injection to form a vapour. Accordingly, the precursor gas may be formed by (e.g. direct) evaporation of a liquid precursor, e.g. on injection of the liquid precursor into the reaction chamber. The method may be a method of forming the composite particulate material by Aerosol Assisted Chemical Vapour Deposition (AACVD). In AACVD, precursors are transported to the reaction chamber in a liquid-gas aerosol. The liquid droplets in the aerosol typically vaporise on, or shortly after, entry to the reaction chamber. Accordingly, the precursor gas may be formed by vaporisation of liquid precursor droplets in a liquid precursor aerosol.

The method may be carried out as a batch process. For example, following formation of the composite particulate material, fluidisation may be halted and composite particulate material product removed from the reaction chamber before fresh particles of the first material are added to the reaction chamber and the process restarted.

Alternatively, the method may be carried out as part of a continuous or semi-continuous process comprising continuously or periodically adding particles of the first material to the reaction chamber and/or removing composite particulate material from the reaction chamber, typically without stopping fluidisation. The method may further comprise continuously or periodically supplying fresh precursor gas to the reaction chamber.

### Temperature

The method may comprise heating the reaction chamber to a temperature of no less than about 100°C, for example, no less than about 200°C, or no less than about 300°C, or no less than about 400°C, or no less than about 450°C. The method may comprise heating the reaction chamber to a temperature of no greater than about 1500°C, for example, no greater than about 1200°C, or no greater than about 1100°C, or no greater than about 1000°C, or no greater than about 950°C, or no greater than about 900°C. The method may comprise heating the reaction chamber to a temperature from about 100°C to about 1500°C, for example, from about 200°C to about 1200°C, or from about 300°C to about 1100°C, or from about 400°C to about 1000°C, or from about 450°C to about 950°C, or from about 450°C to about 900°C.

It will be appreciated that references to heating the reaction chamber to a particular temperature are to be interpreted as heating the contents of the reaction chamber, such as the particles of the first material and/or the precursor gas, to the said temperature.

### First material

The first material may comprise (e.g. be) an electrical conductor, i.e. an electrically conducting material. The first material may comprise (e.g. be) one or more electrically conducting elements (e.g. one or more metals or semi-metals), compounds, alloys or solid solutions.

Alternatively, the first material may comprise (e.g. be) an electrical semiconductor, i.e. a semiconducting material. The first material may comprise (e.g. be) one or more electrically semiconducting elements, compounds, alloys or solid solutions.

Further alternatively, the first material may comprise (e.g. be) an electrical insulator, i.e. an electrically insulating material. The first material may comprise (e.g. be) one or more electrically insulating elements, compounds, alloys or solid solutions.

The first material may comprise (e.g. be) carbon (C). The first material may comprise (e.g. be) carbon in crystalline form (i.e. a crystalline allotrope). For example, the first material may comprise (e.g. be) carbon in the form of diamond or graphitic carbon (e.g. graphite). Additionally or alternatively, the first material may comprise (e.g.) be carbon in amorphous form (i.e. an amorphous allotrope). For example, the first material may comprise (e.g. be) carbon in the form of carbon black, diamond-like carbon or glassy carbon (i.e. vitreous carbon). Additionally or alternatively, the first material may comprise (e.g. be) carbon in one-dimensional or two-dimensional form (i.e. a nanocarbon allotrope). For example, the first material may comprise (e.g. be) carbon in the form of graphene or fullerenic carbon (such as buckminsterfullerenes or carbon nanotubes). Alternatively, the first material may comprise (e.g. be) carbon in non-fullerenic (e.g. non-carbon nanotube) form.

The first material may comprise two or more different carbon phases (e.g. allotropes). For example, the particles of the first material may comprise a particle core of a first carbon phase (e.g. allotrope) and a coating of a second carbon phase (e.g. allotrope). The particles of the first material may each comprise a particle core of graphite and a coating of amorphous carbon. That is to say, the particles of the first material may be particles of graphite coated with amorphous carbon.

The first material may comprise (e.g. be) silicon (Si). The first material may comprise (e.g. be) silicon in crystalline form (i.e. a crystalline allotrope). For example, the first material may comprise (e.g. be) silicon in the form of crystalline silicon, such as single crystal silicon or polycrystalline silicon (i.e. polysilicon), for example nanocrystalline silicon. Additionally or alternatively, the first material may comprise (e.g. be) silicon in amorphous form (i.e. an amorphous allotrope). For example, the first material may comprise (e.g. be) silicon in the form of amorphous silicon, for example hydrogenated amorphous silicon.

The first material may comprise both silicon and carbon. For example, the first material may comprise (e.g. be) silicon carbide (SiC).

The first material may be selected from the group consisting of: graphitic carbon, amorphous carbon, carbon black, amorphous silicon, crystalline silicon; or any combination thereof.

The first material may comprise (e.g. be) a mineral. The first material may comprise (e.g. be) silica (SiO₂). The first material may comprise (e.g. be) crystalline silica or amorphous silica. For example, the first material may comprise (e.g. be) quartz (e.g. α quartz), fused quartz, cristobalite, tridymite, seifertite, stishovite, coesite, fumed silica, silica fume or precipitated silica. Additionally or alternatively, the first material may comprise (e.g. be) a phyllosilicate mineral, such as a serpentine mineral, a clay mineral, a mica group mineral or chlorite. For example, the first material may comprise (e.g. be) antigorite, chrysotile, lizardite, halloysite, kaolinite, illite, montomorillonite, vermiculite, talc, spiolite, palygorskite, pyrophyllite, biotite, fuchsite, muscovite, phlogopite, lepidolite, margarite, glauconite, chlorite. Additionally or alternatively, the first material may comprise (e.g. be) perlite, wollastonite, diatomaceous earth, gypsum, or a zeolite.

The particles of the first material may have an average particle diameter (i.e. d₅₀) of no less than about 1 nm, for example, no less than about 5 nm, or no less than about 10 nm, or no less than about 50 nm, or no less than about 100 nm, or no less than about 150 nm, or no less than about 200 nm, or no less than about 250 nm, or no less than about 300 nm, or no less than about 350 nm, or no less than about 400 nm, or no less than about 450 nm, or no less than about 500 nm, or no less than about 550 nm, or no less than about 600 nm, or no less than about 650 nm, or no less than about 700 nm, or no less than about 750 nm, or no less than about 800 nm, or no less than about 850 nm, or no less than about 900 nm, or no less than about 950 nm, or no less than about 1 µm, or no less than about 5 µm, or no less than about 10 µm, or no less than about 25 µm, or no less than about 50 µm, or no less than about 100 µm. The particles of the first material may have an average particle diameter (i.e. d₅₀) of no greater than about 1000 µm, for example, no greater than about 800 µm, or no greater than about 500 µm, or no greater than about 400 µm, or no greater than about 300 µm, or no greater than about 200 µm, or no greater than about 100 µm, or no greater than about 50 µm, or no greater than about 10 µm, or no greater than about 5 µm, or no greater than about 1 µm, or no greater than about 800 nm, or no greater than about 500 nm, or no greater than about 300 nm, or no greater than about 200 nm, or no greater than about 100 nm. The particles of the first material may have an average particle diameter (i.e. d₅₀) of from about 1 nm to about 1000 µm, for example, from about 1 nm to about 500 µm, or from about 1 nm to about 100 µm, or from about 1 nm to about 1 µm, or from about 1 nm to about 800 nm, or from about 1 nm to about 500 nm, or from about 1 nm to about 300 nm, or from about 1 nm to about 200 nm, or from about 1 nm to about 100 nm, or from about 1 nm to about 50 nm, or from about 1 nm to about 25 nm, or from about 1 nm to about 10 nm, or from about 10 nm to about 100 nm, or from about 10 nm to about 200 nm, or from about 10 nm to about 500 nm, or from about 50 nm to about 100 nm, or from about 50 nm to about 200 nm, or from about 50 nm to about 500 nm, or from about 50 nm to about 1 µm, or from about 100 nm to about 500 nm, or from about 100 nm to about 1 µm, or from about 500 nm to about 1 µm, or from about 500 nm to about 5 µm, or from about 500 nm to about 10 µm, or from about 500 nm to about 100 µm, or from about 500 nm to about 500 µm, or from about 1 µm to about 1000 µm, or from about 1 µm to about 500 µm, or from about 1 µm to about 250 µm, or from about 1 µm to about 100 µm, or from about 1 µm to about 50 µm, or from about 1 µm to about 10 µm, or from about 100 µm to about 1000 µm, or from about 100 µm to about 500 µm, or from about 500 µm to about 1000 µm.

It may be that the particles of the first material are (e.g. substantially) larger than the nanostructures of the second material deposited thereon. That is to say, it may be that the particles of the first material are not nanoscale, i.e. that they are not nanoparticles. The particles of the first material may have an average particle diameter (i.e. d₅₀) of no less than about 0.1 µm, for example, no less than about 1 µm, or no less than about 2 µm. The particles of the first material may have an average particle diameter (i.e. d₅₀) of no greater than about 40 µm, for example, no greater than about 30 µm, or no greater than about 20 µm. The particles of the first material may have an average particle diameter (i.e. d₅₀) of from about 0.1 µm to about 40 µm, for example, from about 1 µm to about 30 µm, or from about 2 µm to about 20 µm.

Unless stated otherwise, particle size properties referred to herein are measured in a well-known manner by sedimentation of the particulate filler or material in a fully dispersed condition in an aqueous medium using a Sedigraph 5100 machine as supplied by Micromeritics Instruments Corporation, Norcross, Georgia, USA (web-site: www.micromeritics.com), referred to herein as a "Micromeritics Sedigraph 5100 unit". Such a machine provides measurements and a plot of the cumulative percentage by weight of particles having a size, referred to in the art as the 'equivalent spherical diameter' (e.s.d), less than given e.s.d values. The mean particle size d₅₀ is the value determined in this way of the particle e.s.d at which there are 50% by weight of the particles which have an equivalent spherical diameter less than that d₅₀ value. The d₉₈, d₉₀ and the d₁₀ are the values determined in this way of the particle e.s.d. at which there are 98%, 90% and 10% respectively by weight of the particles which have an equivalent spherical diameter less than that d₉₈, d₉₀ or d₁₀ value.

Particle size properties may also be measured by wet Malvern laser scattering (standard ISO 13320-1). In this technique, the size of particles in powders, suspensions and emulsions may be measured using the diffraction of a laser beam, based on the application of Mie theory. Such a machine, for example a Malvern Mastersizer S (as supplied by Malvern instruments) provides measurements and a plot of the cumulative percentage by volume of particles having a size, referred to in the art as the "equivalent spherical diameter" (e.s.d), less than given e.s.d values. The mean particle size d₅₀ is the value determined in this way of the particle e.s.d. at which there are 50% by volume of the particles which have an equivalent spherical diameter less than that d₅₀ value. For the avoidance of doubt, the measurement of particle size using laser light scattering is not an equivalent method to the sedimentation method referred to above.

Particle size properties may also be measured by dynamic light scattering (DLS), for example using a Malvern Zetasizer Nano (as supplied by Malvern instruments), or by X-ray Disc Centrifuge (XDC), for example using a BI-XDC Particle Size Analyzer (as supplied by Brookhaven instruments). DLS and XDC are suitable for measuring the size of particles having d₅₀ values below 0.5 µm. Particle sizes below about 1 µm may also be measured using Scanning Electron Microscopy (SEM) or Transmission Electron Microscopy (TEM).

### Second material

The second material may comprise (e.g. be) an electrical conductor, i.e. an electrically conducting material. The second material may comprise (e.g. be) one or more electrically conducting elements (e.g. one or more metals or semi-metals), compounds, alloys or solid solutions.

Alternatively, the second material may comprise (e.g. be) an electrical semiconductor, i.e. a semiconducting material. The first material may comprise (e.g. be) one or more electrically semiconducting elements, compounds, alloys or solid solutions.

The second material may comprise (e.g. be) an elemental semiconductor. For example, the second material may comprise (e.g. be) a Group IV elemental semiconductor such as silicon (Si) or germanium (Ge).

The second material may comprise (e.g. be) a mixture of elemental semiconductors. For example, the second material comprise (e.g. be) a mixture of silicon and germanium, i.e. a silicon-germanium (Si₁₋ₓGₓ) alloy.

The second material may comprise (e.g. be) a compound semiconductor. For example, the second material may comprise (e.g. be) a Group IV compound semiconductor such as silicon carbide (SiC). Additionally or alternatively, the second material may comprise (e.g. be) a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP). Additionally or alternatively, the second material may comprise (e.g. be) a II-VI semiconductor such as zinc oxide (ZnO), zinc telluride (ZnTe) or cadmium telluride (CdTe). The second material may comprise (e.g. be) a mixture of Group IV, III-V and/or II-VI semiconductors.

Accordingly, it may be that the second material is selected from: a Group IV elemental semiconductor such as silicon (Si) or germanium (Ge); a Group IV compound semiconductor such as silicon carbide (SiC); a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP); a II-VI semiconductor such as zinc oxide (ZnO), zinc telluride (ZnTe) or cadmium telluride (CdTe); or any combination thereof.

The second material may be doped, i.e. the second material may comprise one or more dopants. The second material may be an n-type semiconductor comprising one or more donor dopants. The second material may be a p-type semiconductor comprising one or more acceptor dopants. Dopants may include, dependent on the principle semiconductor material present: boron, aluminium, gallium, indium, phosphorous, arsenic, antimony, bismuth, lithium, tellurium, sulphur, beryllium, zinc, chromium, selenium, magnesium, silicon, germanium, carbon, iodine, fluorine and/or sodium.

### Precursor

The precursor gas typically comprises (e.g. consists of) one or more species which, under reaction conditions, decompose to form the second material. For example, the precursor gas may comprise (e.g. consist of) one or more species which decompose to form the second material on exposure to the catalyst, for example at the temperatures and/or pressures achieved in the reaction chamber of the fluidized bed reactor.

Accordingly, the precursor gas may comprise (e.g. be) a semiconductor precursor gas, i.e. a precursor gas which decomposes to form a semiconductor material. The precursor gas may comprise (e.g. consist of) one or more species which contain silicon, germanium, carbon, gallium, arsenic, nitrogen, phosphorous, indium, zinc, tellurium and/or cadmium. For example, the precursor gas may comprise (e.g. consist of) one or more species which contain silicon, germanium, gallium, arsenic, phosphorous, indium, zinc, tellurium and/or cadmium. The precursor gas may comprise a mixture of different semiconductor precursor gases (i.e. a mixture of different chemical species, two or more of the chemical species containing different elements selected from: silicon, germanium, gallium, arsenic, phosphorous, indium, zinc, tellurium and cadmium).

The precursor gas may comprise (e.g. be) a silicon precursor gas, i.e. a precursor gas which decomposes to form silicon. Accordingly, the precursor gas may comprise (e.g. be) a silicon-containing precursor gas, i.e. a precursor gas comprising silicon-containing species. The precursor gas may comprise (e.g. be) a silane, i.e. a saturated inorganic compound comprising a chain of one or more linked silicon atoms, each being a tetrahedral centre of multiple single bonds. The silanes form a homologous series having the general formula SiₙH₂ₙ₊₂, the series being analogous to the alkanes with carbon atoms replaced by silicon atoms. For example, the precursor gas may comprise (e.g. be) (mono-)silane (SiH₄), disilane (Si₂H₆), trisilane (Si₃H₈) or tetrasilane (Si₄H₁₀).

The precursor gas may comprise (e.g. be) a substituted silane. The precursor gas may comprise (e.g. be) a halosilane, i.e. a silane in which one or more hydrogen atoms has been replaced a halogen, such as chlorosilane (H₃SiCl), dichlorosilane (H₂SiCl₂), trichlorosilane (HSiCl₃) or tetrachlorosilane (SiCl₄). The precursor gas may comprise (e.g. be) an organosilane, i.e. a silane in which one or more hydrogen atoms has been replaced by an organic group, such as methylsilane (CH₃SiH₃), dimethylsilane (C₂H₆SiH₂), tetraethylsilane (C₄H₁₂Si), phenylsilane (C₆H₅SiH₃). The precursor gas may comprise (e.g. be) a silane comprising both halogen and organic groups, such as dimethyldichlorosilane (Si(CH₃)₂Cl₂).

The precursor gas may comprise (e.g. be) a germanium precursor gas, i.e. a precursor gas which decomposes to form germanium. Accordingly, the precursor gas may comprise (e.g. be) a germanium-containing precursor gas, i.e. a precursor gas comprising germanium-containing species. The precursor gas may comprise (e.g. be) a germane, i.e. a saturated inorganic compound comprising a chain of one or more linked germanium atoms, each being a tetrahedral centre of multiple single bonds. For example, the precursor gas may comprise (e.g. be) (mono-)germane (GeH₄) or digermane (Ge₂H₆).

The precursor gas may comprise (e.g. be) a substituted germane. The precursor gas may comprise (e.g. be) a halogermane, i.e. a germane in which one or more hydrogen atoms has been replaced a halogen, such as germanium tetrachloride (GeCl₄). The precursor gas may comprise (e.g. be) an organogermane, i.e. a germane in which one or more hydrogen atoms has been replaced by an organic group, such as isobutylgermane ((CH₃)₂CHCH₂GeH₃) or tetraethylgermanium ((CH₃CH₂)₄Ge).

The precursor gas may comprise (e.g. consist of) one or more species having boiling points (e.g. a normal boiling point (i.e. a boiling point measured at 1 atmosphere of pressure) or a standard boiling point (i.e. a boiling point measured at 1 bar of pressure)) of less than about 400°C, for example, less than about 300°C, or less than about 200°C, or less than about 100°C, or less than about 50°C, or less than about 0°C. The precursor gas may comprise (e.g. consist of) one or more species which exist in vapour form (e.g. at a pressure of about 1 atmosphere or about 1 bar) at a temperature of no less than about 0°C, for example, no less than about 50°C, or no less than about 100°C, or no less than about 200°C, or no less than about 300°C, or no less than about 400°C, or no less than about 450°C. The precursor gas may comprise (e.g. consist of) one or more species which exist in vapour form (e.g. at a pressure of about 1 atmosphere or about 1 bar) at a temperature of no greater than about 1500°C, for example, no greater than about 1400°C, or no greater than about 1300°C, or no greater than about 1200°C, or no greater than about 1100°C, or no greater than about 1000°C, or no greater than about 950°C, or no greater than about 900°C. The precursor gas may comprise (e.g. consist of) species which exist in vapour form (e.g. at a pressure of about 1 atmosphere or about 1 bar) at a temperature from about 0°C to about 1500°C, for example, from about 200°C to about 1300°C, or from about 300°C to about 1200°C, or from about 300°C to about 1100°C, or from about 400°C to about 1000°C, or from about 450°C to about 950°C, or from about 450°C to about 900°C.

The decomposition of the precursor gas may be a one-step process. The precursor gas may decompose directly to form the second material. For example, monosilane (SiH₄) may decompose directly to form silicon.

Alternatively, the decomposition of the precursor gas may be a multi-step process (e.g. a two-step process). The precursor gas may decompose to form an intermediate species, the intermediate species subsequently decomposing to form the second material. For example, phenylsilane may decompose to form monosilane, and monosilane may subsequently decompose to form silicon. Decomposition of phenysilane may be temperature-driven, whereas decomposition of monosilane may involve interaction of the monosilane with the catalyst.

The precursor gas may be a primary precursor gas which reacts (e.g. decomposes) to form a secondary precursor gas, the secondary precursor gas decomposing in the presence of the catalyst to form the second material. Alternatively, the precursor gas may be the secondary precursor gas, formed from the primary precursor gas. Reaction (e.g. decomposition) of the primary precursor gas to form the secondary precursor gas may be temperature-dependent. For example, the primary precursor gas may react (e.g. decompose) to form the secondary precursor gas at elevated temperatures, e.g. above a threshold reaction (e.g. decomposition) temperature. For example, the primary precursor gas may be phenylsilane which decomposes at elevated temperatures to form the secondary precursor gas silane, wherein silane decomposes in the presence of the catalyst to form the second material (e.g. silicon).

### Catalyst

The catalyst may comprise (e.g. be) a metal. For example the catalyst may comprise (e.g. be) a metal selected from: gold (Au), platinum (Pt), manganese (Mn), silver (Ag), bismuth (Bi), cadmium (Cd), cobalt (Co), copper (Cu), dysprosium (Dy), iron (Fe), gallium (Ga), gadolinium (Gd), magnesium (Mg), nickel (Ni), osmium (Os), lead (Pb), palladium (Pd), tellurium (Te), titanium (Ti), zinc (Zn), or any combination (e.g. alloy or intermetallic compound) thereof.

The catalyst may comprise (e.g. be) a compound. The catalyst may comprise (e.g. be) an oxide, such as a metal oxide. For example, the catalyst may comprise (e.g. be) an oxide of copper such as cuprous oxide (Cu₂O).

The catalyst may be provided in particulate form. The catalyst may be provided in the form of catalyst nanoparticles.

The catalyst nanoparticles may have an average particle diameter (i.e. d₅₀) of no less than about 0.1 nm, for example, no less than about 0.5 nm, or no less than about 1 nm, or no less than about 5 nm, or no less than about 10 nm. The catalyst nanoparticles may have an average particle diameter (i.e. d₅₀) of no greater than about 1000 nm, for example, no greater than about 500 nm, or no greater than about 250 nm, or no greater than about 100 nm, or no greater than about 50 nm, or no greater than about 25 nm, or no greater than about 10 nm. The catalyst nanoparticles may have an average particle diameter (i.e. d₅₀) of from about 0.1 nm to about 1000 nm, for example, from about 0.1 nm to about 500 nm, or from about 0.1 nm to about 250 nm, or from about 0.1 nm to about 100 nm, or from about 0.1 nm to about 50 nm, or from about 0.1 nm to about 25 nm, or from about 0.1 nm to about 10 nm, or from about 0.5 nm to about 1000 nm, or from about 0.5 nm to about 500 nm, or from about 0.5 nm to about 250 nm, or from about 0.5 nm to about 100 nm, or from about 0.5 nm to about 50 nm, or from about 0.5 nm to about 25 nm, or from about 0.5 nm to about 10 nm, or from about 1 nm to about 1000 nm, or from about 1 nm to about 500 nm, or from about 1 nm to about 250 nm, or from about 1 nm to about 100 nm, or from about 1 nm to about 50 nm, or from about 1 nm to about 25 nm, or from about 1 nm to about 10 nm, or from about 5 nm to about 1000 nm, or from about 5 nm to about 500 nm, or from about 5 nm to about 250 nm, or from about 5 nm to about 100 nm, or from about 5 nm to about 50 nm, or from about 5 nm to about 25 nm, or from about 10 nm to about 1000 nm, or from about 10 nm to about 500 nm, or from about 10 nm to about 250 nm, or from about 10 nm to about 100 nm, or from about 10 nm to about 50 nm, or from about 10 nm to about 25 nm.

The catalyst nanoparticles may have an average particle diameter (i.e. d₅₀) which is no greater than about 75 %, for example, no greater than about 50 %, or no greater than about 25 %, or no greater than about 10 %, or no greater than about 5 %, of the average particle diameter (i.e. d₅₀) of the particles of the first material. The catalyst nanoparticles may have an average particle diameter (i.e. d₅₀) which is no less than about 0.001 %, for example, no less than about 0.01 %, or no less than about 0.1 %, or no less than about 1 %, of the average particle diameter (i.e. d₅₀) of the particles of the first material. The catalyst nanoparticles may have an average particle diameter (i.e. d₅₀) which is from about 0.001 % to about 75 %, for example, from about 0.01 % to about 50 %, or from about 0.1 % to about 25 %, or from about 0.1 % to about 10 %, or from about 1 % to about 10 %, or from about 1 % to about 50 %, or from about 1 % to about 75 %, of the average particle diameter (i.e. d₅₀) of the particles of the first material.

The catalyst nanoparticles may be surface-treated catalyst nanoparticles. For example, the catalyst nanoparticles may be coated catalyst nanoparticles. The catalyst nanoparticles may be coated in a stabilising coating. The stabilising coating may be hydrophobic. The stabilising coating may be organic. The stabilising coating may comprise (e.g. be) a thiol. For example, the stabilising coating may comprise (e.g. be) 1-dodecanethiol (CH₃(CH₂)₁₀CH₂SH).

The catalyst nanoparticles may be suspended in the precursor gas. Additionally or alternatively, the catalyst nanoparticles may be attached to the particles of the first material. The catalyst nanoparticles may adhere to the particles of the first material by virtue of the surface coating. The catalyst nanoparticles may be attached to the particles of the first material prior to fluidisation.

### Solvent

The method may comprise suppling a solvent gas to the reaction chamber of the fluidised bed reactor. The solvent gas may comprise (e.g. be) a solvent for the precursor. The solvent gas may comprise (e.g. be) an organic solvent. For example, the solvent gas may comprise (e.g. be) toluene (also known as toluol or methylbenzene, i.e. C₆H₅CH₃).

The solvent gas may be chemically stable at the temperatures and/or pressures at which the method is carried out. That is to say, the solvent gas may not decompose during formation of the composite particulate material.

The solvent gas may stabilise the precursor gas.

Solvent gas molecules may have a similar molecular structure to precursor gas molecules. It may be that both the solvent gas molecules and the precursor gas molecules are organic. It may be that both the solvent gas molecules and the precursor gas molecules contain a phenyl group.

It may be that the solvent gas comprises (e.g. consists of) toluene and the precursor gas comprises (e.g. consists of) phenylsilane. Without wishing to be bound by theory, the inventors surmise that toluene stabilises phenysilane (due to its similar molecular structure) until sufficiently high temperatures are reached at which phenysilane decomposes to form, for example, monosilane, the monosilane subsequently decomposing to form silicon on interaction with the catalyst. Toluene typically remains stable at temperatures at which phenysilane decomposes.

### Example apparatus

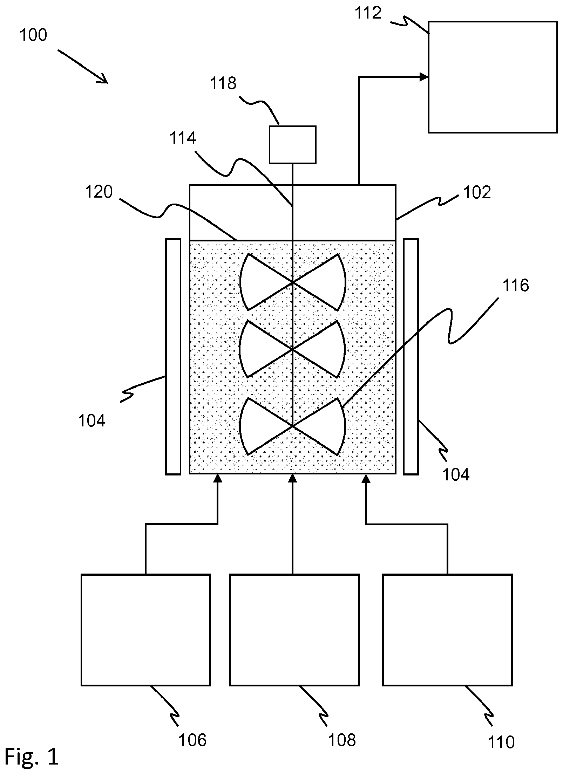

Figure 1 illustrates schematically example deposition apparatus 100 for manufacturing the composite particulate material. The apparatus 100 includes a fluidised bed reaction chamber 102 surrounded by heating elements 104.

The reaction chamber 102 is in fluid communication with a source of precursor gas 106, a source of solvent gas 108 and a source of inert carrier gas 110. Any suitable combination of pumps, valves and filters may be provided between each of the gas sources 106, 108 and 110 and the reaction chamber 102 for controlling a flow of each respective gas into the chamber.

The reaction chamber 102 is also in fluid communication with a collector 112. Again, any suitable combination of pumps, valves and filters may be provided between the reaction chamber 102 and the collector 112 for controlling a flow of material from the chamber to the collector.

The apparatus 100 also includes a mechanical stirrer 114 having a plurality of paddles 116 disposed within the reaction chamber 102. The stirrer is coupled to a stirrer motor 118 configured to drive rotation of the stirrer 114 and the paddles 116 within the chamber 102.

In use, a mixture 120 of the powdered first material and catalyst is provided in the reaction chamber 102. The motor 118 drives rotation of the stirrer 114 and paddles 116 which mechanically fluidise the mixture 120. Inert gas may also be pumped into the chamber 102 from the source 110 to assist in fluidising the particles. The chamber 102 is heated by the heating elements 104. Precursor gas is then pumped into the chamber 102 from the source 106 and solvent gas is pumped into the chamber 102 from the source 108.

As the fluidised particles of the first material and the catalyst are heated in the presence of the precursor gas, the precursor decomposes to form nanostructures of the second material on the fluidised particles of the first material. As the reaction proceeds, the resultant composite particulate material is pumped out of the chamber 102 to the collector 112.

As explained hereinabove, the process may be carried out as a batch process, as a continuous process, or as a semi-continuous process.

### Growth mechanism

It may be that the precursor gas, in the presence of the catalyst, decomposes to deposit nanostructures of the second material onto the fluidised particles of the first material by a Vapour-Liquid-Solid (VLS) growth mechanism. Accordingly, it may be that, under the reaction conditions, the catalyst forms liquid droplets on the particles of the first material. Precursor molecules from the precursor gas may dissolve into the catalyst droplets. Alternatively, precursor molecules may decompose at the surface of the catalyst droplets and decomposition products may dissolve into the catalyst droplets. The precursor molecules or decomposition products may form a supersaturated solution in the catalyst droplets. The second material, whose formation is catalyst by the catalyst droplets, may then nucleate and grow at the interface between each droplet and the particle of the first material. In particular, it may be that the catalyst is a metal and that nanostructures of the second material grow by a VLS mechanism. It may be that the reaction chamber is heated to a temperature equal to or greater than the melting temperature of the catalyst, or at least equal to greater than the eutectic temperature of a mixture (e.g. an alloy) comprising the catalyst and the second material or one or more components thereof.

For example, it may be that the catalyst is provided in the form of nanoparticles of gold, that the first material is carbon, that the second material is silicon, and that the precursor gas is silane. Without wishing to be bound by theory, it is understood that, in such a system, the gold nanoparticles catalyse the decomposition of silane to silicon and hydrogen gas. The silicon dissolves into the gold nanoparticles, forming a solution. Since the reaction chamber is heated above the gold-silicon eutectic temperature (around 363°C), the nanoparticles melt, forming gold-silicon nanodroplets, which are rapidly supersaturated in silicon. Solid silicon therefore precipitates from the liquid at the interface between the droplet and the particle of the first material acting as a nucleation site. Solid silicon nanostructures are then formed by a nucleation and growth mechanism as silicon diffused through the droplet to the interface.

Alternatively, it may be that the precursor gas, in the presence of the catalyst, decomposes to deposit nanostructures of the second material onto the fluidised particles of the first material by a Vapour-Solid-Solid (VSS) growth mechanism. Accordingly, it may be that, under the reaction conditions, the catalyst remains solid (or "quasi-solid"). Precursor molecules may decompose on interaction with the catalyst particles and decomposition products may diffuse (e.g. as a vapour) through the solid catalyst to the interface with the particles of the first material. Decomposition products may then be adsorbed onto the particles of the first material at the interface with the catalyst, thereby forming the second material between the first material and the catalyst. Given that the catalyst need not melt under the reaction conditions, the catalyst may be a compound such as a metal oxide. Accordingly, it may be that the reaction chamber is heated to a temperature lower than the melting temperature of the catalyst.

For example, it may be that the catalyst is provided in the form of nanoparticles of cuprous oxide (Cu₂O), that the first material is carbon, that the second material is silicon, and that the precursor gas is silane. Without wishing to be bound by theory, it is understood that, in such a system, the cuprous oxide nanoparticles catalyse the decomposition of silane to silicon and hydrogen gas. In addition, silane reacts with cuprous oxide to form Cu₃Si which further catalyses the decomposition of silane to silicon vapour. The silicon vapour diffuses through the catalyst nanoparticles to the particle-catalyst interface, where silicon is adsorbed. As more silicon vapour diffuses to the interface, silicon nanostructures are formed.

### Nanostructures

The nanostructures of the second material may have one, two or three nanoscale dimensions.

The nanostructures of the second material may comprise (e.g. be) nanowires of the second material.

The nanowires of the second material may have an (e.g. average) aspect ratio of no less than about 1:1, for example, no less than about 1.5:1, or no less than about 2:1, or no less than about 3:1. The nanowires of the second material may have an (e.g. average) aspect ratio of no more than about 5000:1, for example, no more than about 2500:1, or no more than about 1000:1, or no more than about 500:1, or no more than about 200:1, or no more than about 50:1, or no more than about 25:1 or no more than about 10:1. The nanowires of the second material may have an (e.g. average) aspect ratio from about 1:1 to about 200:1, for example, from about 1:1 to about 100:1, or from about 1:1 to about 50:1, or from about 1.5:1 to about 50:1, or from about 2:1 to about 200:1, or from about 2:1 to about 100:1, or from about 2:1 to about 50:1, or from about 3:1 to about 50:1, or from about 1:1 to about 25:1, or from about 1.5:1 to about 25:1, or from about 2:1 to about 25:1, or from about 3:1 to about 25:1, or from about 1:1 to about 10:1, or from about 1.5:1 to about 10:1, or from about 2:1 to about 10:1, or from about 3:1 to about 10:1, or from about 3:1 to about 200:1, or from about 3:1 to about 100:1, or from about 1:1 to about 5000:1, or from about 1:1 to about 2500:1, or from about 1:1 to about 1000:1, or from about 1:1 to about 500:1, or from about 1.5:1 to about 5000:1, or from about 1.5:1 to about 2500:1, or from about 1.5:1 to about 1000:1, or from about 1.5:1 to about 500:1, or from about 2:1 to about 5000:1, or from about 2:1 to about 2500:1, or from about 2:1 to about 1000:1, or from about 2:1 to about 500:1, or from about 3:1 to about 5000:1, or from about 3:1 to about 2500:1, or from about 3:1 to about 1000:1, or from about 3:1 to about 500:1.

The nanowires of the second material may have an average diameter of no less than about 1 nm, for example, no less than about 10 nm, or no less than about 20 nm, or no less than about 30 nm, or no less than about 40 nm, or no less than about 50 nm. The nanowires of the second material may have an average diameter of no more than about 200 nm, or no more than about 150 nm, or no more than about 100 nm, or no more than about 75 nm, or no more than about 50 nm. The nanowires of the second material may have an average diameter of from about 1 nm to about 200 nm, for example, from about 10 nm to about 150 nm, or from about 10 nm to about 100 nm, or from about 20 nm to about 75 nm, or from about 30 nm to about 50 nm.

The nanowires of the second material may have an average length of no less than about 10 nm, for example, no less than about 25 nm, or no less than about 50 nm, or no less than about 75 nm, or no less than about 100 nm, or no less than about 250 nm, or no less than about 500 nm, or no less than about 750 nm, or no less than about 1 µm, or no less than about 10 µm, or no less than about 20 µm. The nanowires of the second material may have an average length of no more than about 200 µm, for example, no more than about 100 µm, or no more than about 50 µm, or no more than about 10 µm, or no more than about 1 µm, or no more than about 500 nm, or no more than about 250 nm, or no more than about 100 nm, or no more than about 50 nm. The nanowires of the second material may have an average length of from about 10 nm to about 200 µm, for example from about 10 nm to about 50 µm, or from about 10 nm to about 1 µm, or from about 10 nm to about 500 nm, or from about 10 nm to about 100 nm, or from about 10 nm to about 50 nm, or from about 100 nm to about 200 µm, or from about 100 nm to about 50 µm, or from about 100 nm to about 1 µm, or from about 100 nm to about 500 nm, or from about 500 nm to about 200 µm, or from about 500 nm to about 50 µm, or from about 500 nm to about 1 µm, or from about 1 µm to about 200 µm, or from about 1 µm to about 100 µm, or from about 1 µm to about 50 µm, or from about 10 µm to about 200 µm, or from about 10 µm to about 100 µm, or from about 10 µm to about 50 µm, or from about 50 µm to about 200 µm, or from about 50 µm to about 100 µm.

The nanowires of the second material may be crystalline. The nanowires of the second material may have a diamond cubic structure, for example the nanowires may comprise (e.g. consist of) silicon or germanium in a diamond cubic crystal structure. The nanowires may be grown (i.e. predominantly) in <111 > growth direction. For example, it may be that greater than 90 %, for example greater than 95 %, of the nanowires are grown in the <111 > growth direction.

The nanowires of the second material may be anchored to the particles of the first material.

The nanowires of the second material may comprise linear nanowires. Additionally or alternatively, the nanowires of the second material may comprise branched nanowires.

Additionally or alternatively, the nanostructures of the second material may comprise (e.g. be) one or more of the following: nanotextured surfaces, nanoflakes, nanofoams, nanoparticles, nanoribbons, nanotubes.

### Composite particulate material

The composite particulate material formed by the method may comprise particles having: a particle core formed of the first material; and nanostructures of the second material anchored to the particle core.

The particle core may have an average diameter (i.e. d₅₀) of no less than about 1 nm, for example, no less than about 5 nm, or no less than about 10 nm, or no less than about 50 nm, or no less than about 100 nm, or no less than about 150 nm, or no less than about 200 nm, or no less than about 250 nm, or no less than about 300 nm, or no less than about 350 nm, or no less than about 400 nm, or no less than about 450 nm, or no less than about 500 nm, or no less than about 550 nm, or no less than about 600 nm, or no less than about 650 nm, or no less than about 700 nm, or no less than about 750 nm, or no less than about 800 nm, or no less than about 850 nm, or no less than about 900 nm, or no less than about 950 nm, or no less than about 1 µm, or no less than about 2 µm, or no less than about 5 µm, or no less than about 10 µm, or no less than about 25 µm, or no less than about 50 µm, or no less than about 100 µm. The particle core may have an average diameter (i.e. d₅₀) of no greater than about 1000 µm, for example, no greater than about 800 µm, or no greater than about 500 µm, or no greater than about 400 µm, or no greater than about 300 µm, or no greater than about 200 µm, or no greater than about 100 µm, or no greater than about 50 µm, or no greater than about 20 µm, or no greater than about 10 µm, or no greater than about 5 µm, or no greater than about 1 µm, or no greater than about 800 nm, or no greater than about 500 nm, or no greater than about 300 nm, or no greater than about 200 nm, or no greater than about 100 nm. The particle core may have an average diameter (i.e. d₅₀) of from about 1 nm to about 1000 µm, for example, from about 1 nm to about 500 µm, or from about 1 nm to about 100 µm, or from about 1 nm to about 1 µm, or from about 1 nm to about 800 nm, or from about 1 nm to about 500 nm, or from about 1 nm to about 300 nm, or from about 1 nm to about 200 nm, or from about 1 nm to about 100 nm, or from about 1 nm to about 50 nm, or from about 1 nm to about 25 nm, or from about 1 nm to about 10 nm, or from about 10 nm to about 100 nm, or from about 10 nm to about 200 nm, or from about 10 nm to about 500 nm, or from about 50 nm to about 100 nm, or from about 50 nm to about 200 nm, or from about 50 nm to about 500 nm, or from about 50 nm to about 1 µm, or from about 100 nm to about 500 nm, or from about 100 nm to about 1 µm, or from about 500 nm to about 1 µm, or from about 500 nm to about 5 µm, or from about 500 nm to about 10 µm, or from about 500 nm to about 100 µm, or from about 500 nm to about 500 µm, or from about 1 µm to about 1000 µm, or from about 1 µm to about 500 µm, or from about 1 µm to about 250 µm, or from about 1 µm to about 100 µm, or from about 1 µm to about 50 µm, or from about 1 µm to about 20 µm, or from about 2 µm to about 20 µm, or from about 1 µm to about 10 µm, or from about 100 µm to about 1000 µm, or from about 100 µm to about 500 µm, or from about 500 µm to about 1000 µm.

The nanostructures of the second material anchored to the particle core may be nanowires of the second material.

It may be that each particle of the composite particulate material comprises, on average, no less about 1, or no less than about 2, or no less than about 3, or no less than about 10, or no less than about 20, nanowires of the second material. It may be that each particle of the composite particulate material comprises, on average, no more than about 500, for example, no more than about 250, or no more than about 100, nanowires of the second material. It may be that the each particle of the composite particulate material comprises, on average, from about 1 to about 500, for example, from about 2 to about 250, or from about 3 to about 100, nanowires of the second material.

The nanowires of the second material may have an (e.g. average) aspect ratio of no less than about 1:1, for example, no less than about 1.5:1, or no less than about 2:1, or no less than about 3:1. The nanowires of the second material may have an (e.g. average) aspect ratio of no more than about 5000:1, for example, no more than about 2500:1, or no more than about 1000:1, or no more than about 500:1, or no more than about 200:1, or no more than about 50:1, or no more than about 25:1 or no more than about 10:1. The nanowires of the second material may have an (e.g. average) aspect ratio from about 1:1 to about 200:1, for example, from about 1:1 to about 100:1, or from about 1:1 to about 50:1, or from about 1.5:1 to about 50:1, or from about 2:1 to about 200:1, or from about 2:1 to about 100:1, or from about 2:1 to about 50:1, or from about 3:1 to about 50:1, or from about 1:1 to about 25:1, or from about 1.5:1 to about 25:1, or from about 2:1 to about 25:1, or from about 3:1 to about 25:1, or from about 1:1 to about 10:1, or from about 1.5:1 to about 10:1, or from about 2:1 to about 10:1, or from about 3:1 to about 10:1, or from about 3:1 to about 200:1, or from about 3:1 to about 100:1, or from about 1:1 to about 5000:1, or from about 1:1 to about 2500:1, or from about 1:1 to about 1000:1, or from about 1:1 to about 500:1, or from about 1.5:1 to about 5000:1, or from about 1.5:1 to about 2500:1, or from about 1.5:1 to about 1000:1, or from about 1.5:1 to about 500:1, or from about 2:1 to about 5000:1, or from about 2:1 to about 2500:1, or from about 2:1 to about 1000:1, or from about 2:1 to about 500:1, or from about 3:1 to about 5000:1, or from about 3:1 to about 2500:1, or from about 3:1 to about 1000:1, or from about 3:1 to about 500:1.

The nanowires of the second material may have an average diameter of no less than about 1 nm, for example, no less than about 10 nm, or no less than about 20 nm, or no less than about 30 nm, or no less than about 40 nm, or no less than about 50 nm. The nanowires of the second material may have an average diameter of no more than about 200 nm, or no more than about 150 nm, or no more than about 100 nm, or no more than about 75 nm, or no more than about 50 nm. The nanowires of the second material may have an average diameter of from about 1 nm to about 200 nm, for example, from about 10 nm to about 150 nm, or from about 10 nm to about 100 nm, or from about 20 nm to about 75 nm, or from about 30 nm to about 50 nm.

The nanowires of the second material may have an average length of no less than about 10 nm, for example, no less than about 25 nm, or no less than about 50 nm, or no less than about 75 nm, or no less than about 100 nm, or no less than about 250 nm, or no less than about 500 nm, or no less than about 750 nm, or no less than about 1 µm, or no less than about 10 µm, or no less than about 20 µm. The nanowires of the second material may have an average length of no more than about 200 µm, for example, no more than about 100 µm, or no more than about 50 µm, or no more than about 10 µm, or no more than about 1 µm, or no more than about 500 nm, or no more than about 250 nm, or no more than about 100 nm, or no more than about 50 nm. The nanowires of the second material may have an average length of from about 10 nm to about 200 µm, for example from about 10 nm to about 50 µm, or from about 10 nm to about 1 µm, or from about 10 nm to about 500 nm, or from about 10 nm to about 100 nm, or from about 10 nm to about 50 nm, or from about 100 nm to about 200 µm, or from about 100 nm to about 50 µm, or from about 100 nm to about 1 µm, or from about 100 nm to about 500 nm, or from about 500 nm to about 200 µm, or from about 500 nm to about 50 µm, or from about 500 nm to about 1 µm, or from about 1 µm to about 200 µm, or from about 1 µm to about 100 µm, or from about 1 µm to about 50 µm, or from about 10 µm to about 200 µm, or from about 10 µm to about 100 µm, or from about 10 µm to about 50 µm, or from about 50 µm to about 200 µm, or from about 50 µm to about 100 µm.

Dimensions of the nanowires of the second material may be measured using Scanning Electron Microscopy (SEM) or Transmission Electron Microscopy (TEM).

The nanowires of the second material may be crystalline. The nanowires of the second material may have a diamond cubic structure, for example the nanowires may comprise (e.g. consist of) silicon or germanium in a diamond cubic crystal structure. The nanowires may be grown (i.e. predominantly) in <111 > growth direction. For example, it may be that greater than 90 %, for example greater than 95 %, of the nanowires are grown in the <111 > growth direction.

The nanowires of the second material may comprise linear nanowires. Additionally or alternatively, the nanowires of the second material may comprise branched nanowires.

Additionally or alternatively, the nanostructures of the second material anchored to the particle core may comprise (e.g. be) one or more of the following: nanotextured surfaces, nanoflakes, nanofoams, nanoparticles, nanoribbons, nanotubes.

The composite particulate material may be an electrode active material for use in an electrochemical cell (such as a lithium-ion battery). The electrode active material may be suitable for use in an anode of an electrochemical cell (such as a lithium-ion battery). The electrode active material may have a theoretical lithiation capacity of no less than about 100 mAh/g, for example, no less than about 200 mAh/g, or no less than about 300 mAh/g, or no less than about 400 mAh/g, or no less than about 500 mAh/g, or no less than about 600 mAh/g. The electrode active material may have a theoretical lithiation capacity of no more than about 4000 mAh/g, for example, no more than about 3000 mAh/g, or no more than about 2000 mAh/g, or no more than about 1000 mAh/g, or no more than about 900 mAh/g, or no more than about 800 mAh/g. The electrode active material may have a theoretical lithiation capacity of from about 100 mAh/g to about 4000 mAh/g, for example, from about 100 mAh/g to about 3000 mAh/g, or from about 100 mAh/g to about 2000 mAh/g, or from about 100 mAh/g to about 1000 mAh/g, or from about 200 mAh/g to about 4000 mAh/g, or from about 200 mAh/g to about 3000 mAh/g, or from about 200 mAh/g to about 1000 mAh/g, or from about 200 mAh/g to about 1000 mAh/g, or from about 300 mAh/g to about 4000 mAh/g, or from about 300 mAh/g to about 3000 mAh/g, or from about 300 mAh/g to about 2000 mAh/g, or from about 300 mAh/g to about 1000 mAh/g, or from about 200 mAh/g to about 900 mAh/g, or from about 300 mAh/g to about 900 mAh/g, or from about 400 mAh/g to about 900 mAh/g, or from about 500 mAh/g to about 900 mAh/g, or from about 600 mAh/g to about 900 mAh/g, or from about 300 mAh/g to about 800 mAh/g, or from about 400 mAh/g to about 800 mAh/g.

Accordingly, a method of manufacturing an electrode for an electrochemical cell (such as a lithium-ion battery) may comprise: forming the composite particulate material, the composite particulate material comprising particles having a particle core formed of a first material and nanostructures of a second material attached to the particle core; and forming at least part of the electrode from the composite particulate material without substantial detachment of the nanostructures of the second material from the particle cores of the first material. The electrode may be an anode of the electrochemical cell (e.g. lithium-ion battery).

### Numbered paragraphs

For the avoidance of doubt, the present application is directed to the subject-matter described in the following numbered paragraphs:
1. A method of forming a composite particulate material by Chemical Vapour Deposition (CVD), the method comprising: contacting fluidised particles of a first material with a precursor gas in the presence of a catalyst in a reaction chamber of a fluidised bed reactor at a pressure greater than about 100 Torr; and heating the reaction chamber to a temperature at which the precursor gas, in the presence of the catalyst, decomposes to deposit nanostructures of a second material onto the fluidised particles of the first material.
2. The method according to numbered paragraph 1, wherein contacting fluidised particles of the first material with the precursor gas in the presence of the catalyst in the reaction chamber of the fluidised bed reactor comprises: fluidising the particles of the first material in the reaction chamber at a pressure greater than about 100 Torr; and supplying the precursor gas to the reaction chamber, thereby bringing the fluidised particles and precursor gas into contact.
3. The method according to numbered paragraph 2, wherein fluidising the particles of the first material comprises mechanically agitating or tumbling the particles and/or fluidising the particles in a carrier gas.
4. The method according to any preceding numbered paragraph, wherein the first material is an electrical conductor or semiconductor, for example wherein the first material comprises carbon (C) or silicon (Si), optionally wherein the first material is selected from: graphitic carbon, amorphous carbon, carbon black, amorphous silicon, crystalline silicon; or any combination thereof.
5. The method according to any preceding numbered paragraph, wherein the second material is an electrical conductor or semiconductor, for example wherein the second material is selected from: a Group IV elemental semiconductor such as silicon (Si) or germanium (Ge); a Group IV compound semiconductor such as silicon carbide (SiC); a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP); a II-VI semiconductor such as zinc oxide (ZnO), zinc telluride (ZnTe) or cadmium telluride (CdTe); or any combination thereof.
6. The method according to any preceding numbered paragraph, wherein the precursor gas is a silicon precursor gas or a germanium precursor gas, for example wherein the precursor gas is a silane, a halosilane such as tetrachlorosilane (SiCl₄), an organosilane such as phenylsilane (C₆H₅SiH₃), a germane, a halogermane, or an organogermane.
7. The method according to any preceding numbered paragraph further comprising suppling a solvent gas to the reaction chamber of the fluidised bed reactor, the solvent gas optionally being an organic solvent gas such as toluene.
8. The method according to any preceding numbered paragraph, wherein the catalyst is provided in the form of catalyst nanoparticles, the catalyst nanoparticles optionally being suspended in the precursor gas or attached to the fluidised particles of the first material.
9. The method according to numbered paragraph 8, wherein the catalyst nanoparticles are coated in a stabilising coating, for example comprising 1-dodecanethiol (CH₃(CH₂)₁₀CH₂SH).
10. The method according to any preceding numbered paragraph, wherein: (a) the catalyst is a metal, for example selected from: gold (Au), platinum (Pt), manganese (Mn), silver (Ag), bismuth (Bi), cadmium (Cd), cobalt (Co), copper (Cu), dysprosium (Dy), iron (Fe), gallium (Ga), gadolinium (Gd), magnesium (Mg), nickel (Ni), osmium (Os), lead (Pb), palladium (Pd), tellurium (Te), titanium (Ti), zinc (Zn), or any combination thereof; or (b) the catalyst is a metal oxide, for example cuprous oxide (Cu₂O).
11. The method according to any preceding numbered paragraph, wherein the method comprises: heating the reaction chamber to a temperature no less than about 400°C, for example from about 400°C to about 1000°C, or from about 450°C to about 900°C; and/or contacting the fluidised particles of the first material with the precursor gas at a pressure greater than about 100 Torr and less than or equal to about 7500 Torr, for example, from about 250 Torr to about 3000 Torr, or from about 500 Torr to about 1500 Torr.
12. The method according to any preceding numbered paragraph, wherein the method is a method of forming the composite particulate material by Liquid Injection Chemical Vapour Deposition (ICVD).
13. The method according to any preceding numbered paragraph, wherein the precursor gas, in the presence of the catalyst, decomposes to deposit nanostructures of the second material onto the fluidised particles of the first material by a Vapour-Liquid-Solid (VLS) or a Vapour-Solid-Solid (VSS) growth mechanism.
14. The method according to any preceding numbered paragraph, wherein the precursor gas decomposes to deposit nanowires of the second material anchored to the fluidised particles.
15. The method according to any preceding numbered paragraph, wherein the method is carried out: (a) as a batch process; or (b) as part of a continuous or semi-continuous process comprising continuously or periodically adding particles of the first material to the reaction chamber and/or removing composite particulate material from the reaction chamber.
16. The method according to any preceding numbered paragraph, wherein the composite particulate material is an electrode active material for use in an electrochemical cell.
17. A method of manufacturing an electrode for an electrochemical cell, the method comprising: forming a composite particulate material by the method according to any preceding numbered paragraph, the composite particulate material comprising particles having a particle core formed of a first material and nanostructures of a second material attached to the particle core; and forming at least part of the electrode from the composite particulate material without substantial detachment of the nanostructures of the second material from the particle cores of the first material.
18. A composite particulate material formed by the method according to any of numbered paragraphs 1 to 16.
19. The composite particulate material according to numbered paragraph 18, wherein the composite particulate material comprises particles having: a particle core formed of a first material; and nanowires of a second material anchored to the particle core.
20. The composite particulate material according to numbered paragraph 19, wherein the first material comprises carbon (C) or silicon (Si), for example wherein the first material is selected from: graphitic carbon, amorphous carbon, carbon black, amorphous silicon, crystalline silicon, or any combination thereof.
21. The composite particulate material according to numbered paragraph 19 or numbered paragraph 20, wherein the second material is an electrical conductor or semiconductor, for example wherein the second material is selected from: a Group IV elemental semiconductor such as silicon (Si) or germanium (Ge); a Group IV compound semiconductor such as silicon carbide (SiC); a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP); a II-VI semiconductor such as zinc oxide (ZnO), zinc telluride (ZnTe) or cadmium telluride (CdTe); or any combination thereof.
22. The composite particulate material according to any of numbered paragraphs 18 to 21, wherein the composite particulate material is an electrode active material for use in an electrochemical cell.
23. An electrode for an electrochemical cell manufactured by the method of numbered paragraph 17.

## Claims

1. A method of forming a composite particulate material by Chemical Vapour Deposition (CVD), the method comprising:
contacting fluidised particles of a first material with a precursor gas in the presence of a catalyst in a reaction chamber of a fluidised bed reactor at a pressure greater than about 100 Torr; and
heating the reaction chamber to a temperature at which the precursor gas, in the presence of the catalyst, decomposes to deposit nanostructures of a second material onto the fluidised particles of the first material.

2. The method according to claim 1, wherein contacting fluidised particles of the first material with the precursor gas in the presence of the catalyst in the reaction chamber of the fluidised bed reactor comprises:
fluidising the particles of the first material in the reaction chamber at a pressure greater than about 100 Torr; and
supplying the precursor gas to the reaction chamber, thereby bringing the fluidised particles and precursor gas into contact;
optionally wherein fluidising the particles of the first material comprises mechanically agitating or tumbling the particles and/or fluidising the particles in a carrier gas.

3. The method according to claim 1 or claim 2, wherein:
the first material is an electrical conductor or semiconductor, for example wherein the first material comprises carbon (C) or silicon (Si), optionally wherein the first material is selected from: graphitic carbon, amorphous carbon, carbon black, amorphous silicon, crystalline silicon; or any combination thereof; and/or
the second material is an electrical conductor or semiconductor, for example wherein the second material is selected from: a Group IV elemental semiconductor such as silicon (Si) or germanium (Ge); a Group IV compound semiconductor such as silicon carbide (SiC); a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP); a II-VI semiconductor such as zinc oxide (ZnO), zinc telluride (ZnTe) or cadmium telluride (CdTe); or any combination thereof; and/or
the precursor gas is a silicon precursor gas or a germanium precursor gas, for example wherein the precursor gas is a silane, a halosilane such as tetrachlorosilane (SiCl₄), an organosilane such as phenylsilane (C₆H₅SiH₃), a germane, a halogermane, or an organogermane.

4. The method according to any preceding claim further comprising suppling a solvent gas to the reaction chamber of the fluidised bed reactor, the solvent gas optionally being an organic solvent gas such as toluene.

5. The method according to any preceding claim, wherein:
(A) the catalyst is provided in the form of catalyst nanoparticles, the catalyst nanoparticles optionally being suspended in the precursor gas or attached to the fluidised particles of the first material, the catalyst nanoparticles further optionally being coated in a stabilising coating, for example comprising 1-dodecanethiol (CH₃(CH₂)₁₀CH₂SH); and/or
(B)
(a) the catalyst is a metal, for example selected from: gold (Au), platinum (Pt), manganese (Mn), silver (Ag), bismuth (Bi), cadmium (Cd), cobalt (Co), copper (Cu), dysprosium (Dy), iron (Fe), gallium (Ga), gadolinium (Gd), magnesium (Mg), nickel (Ni), osmium (Os), lead (Pb), palladium (Pd), tellurium (Te), titanium (Ti), zinc (Zn), or any combination thereof; or
(b) the catalyst is a metal oxide, for example cuprous oxide (Cu₂O).

6. The method according to any preceding claim, wherein the method comprises:
heating the reaction chamber to a temperature no less than about 400°C, for example from about 400°C to about 1000°C, or from about 450°C to about 900°C; and/or
contacting the fluidised particles of the first material with the precursor gas at a pressure greater than about 100 Torr and less than or equal to about 7500 Torr, for example, from about 250 Torr to about 3000 Torr, or from about 500 Torr to about 1500 Torr.

7. The method according to any preceding claim, wherein the method is a method of forming the composite particulate material by Liquid Injection Chemical Vapour Deposition (LICVD).

8. The method according to any preceding claim, wherein:
the precursor gas, in the presence of the catalyst, decomposes to deposit nanostructures of the second material onto the fluidised particles of the first material by a Vapour-Liquid-Solid (VLS) or a Vapour-Solid-Solid (VSS) growth mechanism; and/or
the precursor gas decomposes to deposit nanowires of the second material anchored to the fluidised particles.

9. The method according to any preceding claim, wherein the method is carried out:
(a) as a batch process; or
(b) as part of a continuous or semi-continuous process comprising continuously or periodically adding particles of the first material to the reaction chamber and/or removing composite particulate material from the reaction chamber.

10. The method according to any preceding claim, wherein the composite particulate material is an electrode active material for use in an electrochemical cell.

11. A method of manufacturing an electrode for an electrochemical cell, the method comprising:
forming a composite particulate material by the method according to any preceding claim, the composite particulate material comprising particles having a particle core formed of a first material and nanostructures of a second material attached to the particle core; and
forming at least part of the electrode from the composite particulate material without substantial detachment of the nanostructures of the second material from the particle cores of the first material.

12. A composite particulate material formed by the method according to any of claims 1 to 10.

13. The composite particulate material according to claim 12, wherein the composite particulate material comprises particles having:
a particle core formed of a first material; and
nanowires of a second material anchored to the particle core;
optionally wherein:
the first material comprises carbon (C) or silicon (Si), for example wherein the first material is selected from: graphitic carbon, amorphous carbon, carbon black, amorphous silicon, crystalline silicon, or any combination thereof; and/or
the second material is an electrical conductor or semiconductor, for example wherein the second material is selected from: a Group IV elemental semiconductor such as silicon (Si) or germanium (Ge); a Group IV compound semiconductor such as silicon carbide (SiC); a III-V semiconductor such as gallium arsenide (GaAs), gallium nitride (GaN), gallium phosphide (GaP), aluminium gallium arsenide (AIGaAs), indium arsenide (InAs), indium nitride (InN) or indium phosphide (InP); a II-VI semiconductor such as zinc oxide (ZnO), zinc telluride (ZnTe) or cadmium telluride (CdTe); or any combination thereof.

14. The composite particulate material according to claim 12 or claim 13, wherein the composite particulate material is an electrode active material for use in an electrochemical cell.

15. An electrode for an electrochemical cell manufactured by the method of claim 11.
